# EUROPÄISCHE PATENTANMELDUNG

(11) **EP 2 669 410 A1**
(43) Veröffentlichungstag der Anmeldung: **04.12.2013**
(21) Anmeldenummer: 13168892.1
(22) Anmeldetag: 23.05.2013
(51) Int. Cl.: C30B 11/10, C30B 29/20

(54) **Verfahren zur Kristallzüchtung durch ein Flammenschmelzen**

(30) Priorität: 31.05.2012 AT 502122012
(71) Anmelder: Innotech Holding GmbH, 4694 Ohlsdorf (AT)
(72) Erfinder: Reiter, Gerald, 4694 Ohlsdorf (AT)
(74) Vertreter: Hübscher, Helmut

(57) **Zusammenfassung**

Es wird ein Verfahren zur Kristallzüchtung durch ein Flammenschmelzen eines aus der Asche eines biogenen Körpers gewonnenen Metalloxidpulvers beschrieben, wobei zunächst zur Einleitung des Züchtungsvorgangs auf einem Sinterkegel (12) oder einem Keimkristall eine polykristalline Schmelzperle aufgeschmolzen und die sich bildende Kristallkuppe allmählich auf den gewünschten Kristalldurchmesser verbreitert wird, bevor eine Kristallbirne (14) mit konstantem Durchmesser gezüchtet wird. Um gute Züchtungsergebnisse beim Einsatz geringer Mengen an Metalloxidpulver von biogenen Körpern zu erhalten, wird vorgeschlagen, dass das Metalloxidpulver aus der Asche des biogenen Körpers erst zur Züchtung der Kristallbirne (14) nach der mit einem gleichartigen, nicht vom biogenen Körper stammenden Metalloxidpulver durchgeführten Einleitung des Züchtungsvorgangs eingesetzt wird.

## Beschreibung

Die Erfindung bezieht sich auf ein Verfahren zur Kristallzüchtung durch ein Flammenschmelzen eines aus der Asche eines biogenen Körpers gewonnenen Metalloxidpulvers, wobei zunächst zur Einleitung des Züchtungsvorgangs auf einem Sinterkegel oder einem Keimkristall eine polykristalline Schmelzperle aufgeschmolzen und die sich bildende Kristallkuppe allmählich auf den gewünschten Kristalldurchmesser verbreitert wird, bevor eine Kristallbirne mit konstantem Durchmesser gezüchtet wird.

Zur Züchtung von Rubin- und Saphirkristallen ist es bekannt, ein nach Verneuil benanntes Flammenschmelzverfahren einzusetzen, gemäß dem ein dotiertes Aluminiumoxidpulver in einer vertikalen Anordnung einer Knallgasflamme zugeführt wird, die auf der Kuppe des wachsenden Kristalls einen dünnen Schmelzfilm erzeugt. Das zugeführte Aluminiumoxidpulver schmilzt zum Teil in der Flamme und zum Teil beim Auftreffen auf den Schmelzfilm, auf dessen Unterseite die Kristallisation erfolgt. Entsprechend der Wachstumsrate wird der entstehende Kristall unter einer Rotation um eine in Wachstumsrichtung verlaufende Achse nach unten abgesenkt, um gleichbleibende Kristallisationsbedingungen zu sichern.

Zur Einleitung des Züchtungsvorgangs wird auf einem Sinterkegel eine polykristalline Schweißperle aufgeschmolzen und durch Keimauslese in einem Dünnhals ein einkristallines Wachstum erreicht. Es ist aber auch möglich, von einem einkristallinen Keimkristall auszugehen, auf dem eine Schweißperle aufgeschmolzen wird. Die Verbreiterung des aufwachsenden Kristalls auf den erwünschten Kristalldurchmesser erfolgt durch eine Verstärkung der Knallgasflamme, bevor nach dieser Einleitung des Züchtungsvorgangs der eigentliche Kristall im Bereich der sogenannten Kristallbirne mit konstantem Durchmesser aufwächst.

Aus der Asche biogener Körper können Aluminiumoxidpulver, unter Umständen aber auch andere Metalloxidpulver gewonnen werden, welche Pulver sich zur Kristallzüchtung durch ein Flammenschmelzen eignen, wobei die Farbe der beispielsweise gezüchteten Rubine oder Saphire auch von der Art des Tiers abhängt, von dem der biogene Körper stammt, weil sich von der Tierart abhängige, unterschiedliche Dotierungen des aus der Asche gewonnenen Metalloxids ergeben, was eine vorteilhafte Voraussetzung für die Züchtung von für eine Tierart charakteristischen Kristallen, insbesondere Rubinen oder Saphiren, aus der Asche verbrannter Tierkörper darstellt. Allerdings ist die aus der Asche eines Tierkörpers gewinnbare Menge an Metalloxidpulvern insbesondere bei kleineren Tierarten zur Züchtung eines beispielsweise als Schmuckstein einsetzbaren Kristalls zu gering.

Der Erfindung liegt somit die Aufgabe zugrunde, ein Verfahren zur Züchtung von Kristallen anzugeben, mit dessen Hilfe auch mit vergleichsweise kleinen Mengen eines von einem biogenen Körper stammenden Metalloxidpulvers ein als Schmuckstein einsetzbarer Kristall gezüchtet werden kann.

Ausgehend von einem Verfahren der eingangs geschilderten Art löst die Erfindung die gestellte Aufgabe dadurch, dass das Metalloxidpulver aus der Asche des biogenen Körpers erst zur Züchtung der Kristallbirne nach der mit einem gleichartigen, nicht vom biogenen Körper stammenden Metalloxidpulver durchgeführten Einleitung des Züchtungsvorgangs eingesetzt wird.

Da zufolge dieser Maßnahmen für die Einleitung des Züchtungsvorgangs nicht das für die eigentliche Kristallzüchtung vorgesehene, aus der Asche eines biogenen Körpers gewonnene Metalloxidpulver, sondern ein gleichartiges, nicht vom biogenen Körper stammendes Aluminiumoxidpulver eingesetzt wird, kann das aus der Asche eines biogenen Körpers gewonnene Metalloxidpulver ausschließlich für die Züchtung der Kristallbirne verwendet werden, sodass auch mit vergleichsweise kleinen Mengen an einem solchen Metalloxidpulver aus einem biogenen Körper ein für einen Schmuckstein ausreichend großer Kristall gezüchtet werden kann. Der für die Schmucksteinherstellung unbrauchbare, insbesondere durch den Sinterkegel, die Schmelzperle und die Verbreiterung zur Kristallbirne gebildete Abschnitt zur Einleitung des Züchtungsvorgangs wird ja mit einem nicht vom biogenen Körper stammenden Metalloxidpulver gezogen, wobei auf die Kuppe des aus dem nicht vom biogenen Körper stammenden Metalloxidpulver gezogenen Kristalls der Kristall aus dem Metalloxidpulver des biogenen Körpers aufwächst. Voraussetzung hierfür ist selbstverständlich, dass ein gleichartiges, möglichst reines Metalloxidpulver zum Einsatz kommt, um ein kristallines Aufwachsen der Kristallbirne aus dem Metalloxidpulver des biogenen Körpers zu ermöglichen.

Vorteilhafte wirtschaftliche Verhältnisse ergeben sich, wenn die Kristallbirne mit nacheinander zum Einsatz kommenden, gesondert aus der Asche einzelner biogener Körper gewonnenen Metalloxidpulvern gezüchtet wird, weil in diesem Fall die Einleitung des Züchtungsvorgangs nur einmal für alle in einem Strang zu züchtenden Kristalle vorgenommen werden muss. Stehen jeweils nur geringe Mengen an Metalloxidpulver aus der Asche einzelner biogener Körper zur Verfügung, so empfiehlt es sich, die Kristallbirne zwischen den Metalloxidpulvern aus der Asche einzelner biogener Körper mit einem zwar gleichartigen, aber nicht von den biogenen Körpern stammenden Metalloxidpulver zu züchten, damit Materialverluste, die sich durch das notwendige Verwerfen eines ausreichenden Übergangbereichs zwischen zwei unmittelbar aufeinanderfolgenden Kristallschichten zur eindeutigen Beschränkung der jeweiligen Kristallschicht auf einen biogenen Körper ergeben, durch eine Kristallzwischenschicht aus einem Metalloxidpulver nicht von den biogenen Körpern vermieden werden können.

Zur eindeutigen Abgrenzung der Kristallschichten aus einzelnen biogenen Körpern empfiehlt es sich, die Kristallzwischenschichten aus einem Metalloxidpulver zu züchten, das einen entsprechenden Farbkontrast der Kristallzwischenschichten zu den Kristallabschnitten der biogenen Körper bedingt. Zu diesem Zweck kann zur Einleitung des Züchtungsvorgangs und/oder zur Züchtung der Kristallbirne zwischen den Züchtungsvorgängen mit Metalloxidpulvern aus der Asche einzelner biogener Körper ein undotiertes Metalloxidpulver eingesetzt werden, das im Wesentlichen zu farblosen Kristallen führt.

Anhand der Zeichnung wird das erfindungsgemäße Verfahren näher erläutert. Es zeigen
Fig. 1 eine Vorrichtung zur Kristallzüchtung durch ein Flammenschmelzen gemäß der Erfindung in einem schematischen Blockschaltbild und
Fig. 2 den Aufbau eines Kristalls, der aus den Aluminiumoxidpulvern dreier biogener Körper gezüchtet wurde.

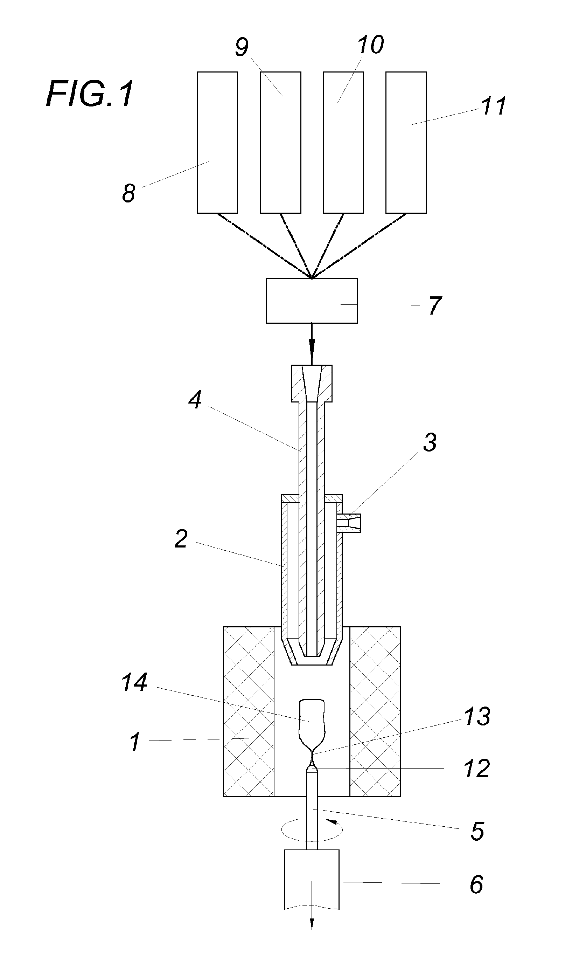

Die in der Fig. 1 dargestellte Vorrichtung zur Züchtung von Kristallen durch ein Flammenschmelzen weist in herkömmlicher Weise eine Brennkammer 1 auf, in die ein Brenner 2 mit vertikaler Achse von oben ragt. Diesem Brenner 2 wird einerseits über einen Anschluss 3 Wasserstoff und anderseits über eine Lanze 4 Sauerstoff zugeführt, sodass die Brennkammer 1 mit einer Knallgasflamme beaufschlagt werden kann. Von der dem Brenner 2 gegenüberliegenden unteren Seite ragt ein zum Brenner 2 koaxialer Keramikstift 5 zur Aufnahme des zu züchtenden Kristalls in die Brennkammer 1. Mit Hilfe eines nicht näher dargestellten Antriebs 6 kann der Keramikstift 5 nicht nur um seine Achse gedreht, sondern auch entsprechend der Wachstumsgeschwindigkeit des Kristalls abgesenkt werden, wie dies durch entsprechende Bewegungspfeile angedeutet ist.

Zum Unterschied zu herkömmlichen Vorrichtungen dieser Art ist die Lanze 4, über die mit Hilfe des Sauerstoffs Aluminiumoxidpulver in die Brennkammer 1 gefördert wird, nicht an einen einzigen Pulverbehälter, sondern über eine Umschalteinrichtung 7 an mehrere Pulverbehälter 8, 9, 10 und 11 angeschlossen, von denen die Pulverbehälter 9, 10 und 11 jeweils ein aus der Asche eines einzigen biogenen Körpers, beispielsweise eines Tiers, gewonnenes Aluminiumoxidpulver und der Pulverbehälter 8 ein nicht dotiertes, aus einer herkömmlichen industriellen Fertigung stammendes Aluminiumoxidpulver enthalten.

Zur Einleitung des Züchtungsvorgangs wird zunächst auf den Keramikstift 5 ein polykristalliner Sinterkegel 12 mit einer Schmelzperle erzeugt, dessen Kuppe aufgeschmolzen wird, um durch eine Keimauslese in einem Dünnhals 13 ein einkristallines Wachstum zu erreichen. Die Verbreiterung auf den gewünschten Kristalldurchmesser der zu züchtenden Kristallbirne 14 erfolgt durch eine Verstärkung der Knallgasflamme, die üblicherweise über den Sauerstoffdruck eingestellt wird. Durch die vergrößerte Wärmezufuhr tritt etwas Schmelze über den Rand der Kristallkuppe und erstarrt dort, wodurch der Kristall breiter wird. Diese Einleitung des Züchtungsvorgangs erfolgt mit dem Aluminiumoxidpulver aus dem Pulverbehälter 8, sodass zum Aufwachsen der Kristalle aus den einzelnen biogenen Körpern bereits ein Kristall mit dem erwünschten Durchmesser vorliegt. Es braucht daher zur Züchtung eines Kristalls aus dem Aluminiumoxidpulver des Pulverbehälters 9 lediglich die Umschalteinrichtung 7 beaufschlagt zu werden, um das Aluminiumoxidpulver des Pulverbehälters 9 zur Kristallzüchtung auf der Kristallbirne 14 durch die Lanze 4 der Brennkammer zuzuführen. Im Anschluss an die Züchtung des Kristalls mit dem Aluminiumoxidpulver aus dem Pulverbehälter 9 wird vorzugsweise eine Kristallzwischenschicht mit dem Aluminiumoxidpulver aus dem Pulverbehälter 8 gezogen, bevor der Pulverbehälter 10 zum Einsatz kommt. Dieser Vorgang wiederholt sich mit den restlichen Pulverbehältern, wobei zum Abschluss wiederum eine Kristallschicht aus dem Aluminiumoxidpulver des Pulverbehälters 8 gezogen wird.

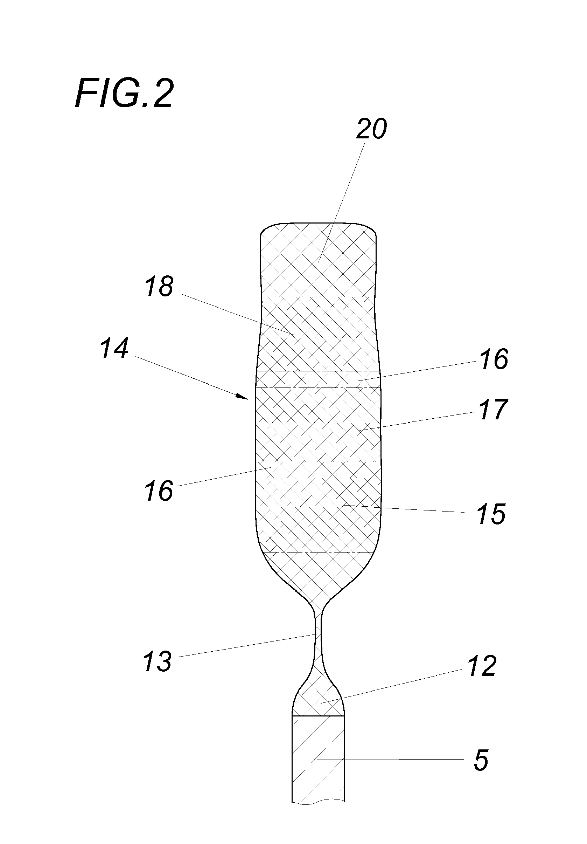

In der Fig. 2 ist der Aufbau eines solchen Kristalls näher dargestellt. Nach Verbreiterung des aufwachsenden Kristalls auf den erwünschten Durchmesser der Kristallbirne 14 wurde ein Kristallabschnitt 15 aufwachsen gelassen, der aus dem Aluminiumoxidpulver des Pulverbehälters 9 gezogen wurde und einem bestimmten biogenen Körper entspricht. Nach einer Kristallzwischenschicht 16 aus dem Aluminiumoxidpulver des Pulverbehälters 8 wird eine weitere Kristallschicht 17 gezogen, und zwar mit einem aus der Asche eines bestimmten biogenen Körpers gewonnenen Aluminiumoxidpulvers, das dem Pulverbehälter 10 entstammt. Nach einer weiteren Kristallzwischenschicht 16 wurde das Aluminiumoxidpulver aus dem Speicherbehälter 11 verarbeitet, das zu einer Kristallschicht 18 führte, die mit einer Kristallschicht 20 wieder aus dem Aluminiumoxidpulver des Pulverbehälters 8 gezogen wurde. Die den einzelnen biogenen Körpern zugehörigen Kristallschichten 15, 17 und 18 können somit voneinander getrennt werden, ohne wesentliche Materialverluste im Bereich dieser Kristallschichten in Kauf nehmen zu müssen.

Obwohl im Allgemeinen aus der Asche biogener Körper vorteilhaft Aluminiumoxidpulver gewonnen werden können, die sich für eine Kristallzüchtung durch ein Flammenschmelzen gut eignen, können unter Umständen auch andere aus der Asche eines biogenen Körpers gewinnbare Metalloxide für die Züchtung von Kristallen durch ein Flammenschmelzen eingesetzt werden, und zwar unter der Voraussetzung, dass diese Metalloxidpulver eine ausreichende Beständigkeit gegenüber den physikalisch-chemischen Bedingungen in der Flamme aufweisen, was in der Regel bei Metalloxiden der Fall ist, und in einer für die Züchtung von als Schmuckstein verwendbaren Kristallen ausreichender Menge vorliegen.

## Patentansprüche

1. Verfahren zur Kristallzüchtung durch ein Flammenschmelzen eines aus der Asche eines biogenen Körpers gewonnenen Metalloxidpulvers, wobei zunächst zur Einleitung des Züchtungsvorgangs auf einem Sinterkegel (12) oder einem Keimkristall eine polykristalline Schmelzperle aufgeschmolzen und die sich bildende Kristallkuppe allmählich auf den gewünschten Kristalldurchmesser verbreitert wird, bevor eine Kristallbirne (14) mit konstantem Durchmesser gezüchtet wird, **dadurch gekennzeichnet, dass** das Metalloxidpulver aus der Asche des biogenen Körpers erst zur Züchtung der Kristallbirne (14) nach der mit einem gleichartigen, nicht vom biogenen Körper stammenden Metalloxidpulver durchgeführten Einleitung des Züchtungsvorgangs eingesetzt wird.

2. Verfahren nach Anspruch 1, **dadurch gekennzeichnet, dass** die Kristallbirne (14) mit nacheinander zum Einsatz kommenden, gesondert aus der Asche einzelner biogener Körper gewonnenen Metalloxidpulvern gezüchtet wird.

3. Verfahren nach Anspruch 2, **dadurch gekennzeichnet, dass** die Kristallbirne (14) zwischen den Metalloxidpulvern aus der Asche einzelner biogener Körper mit einem nicht von den biogenen Körpern stammenden, gleichartigen Metalloxidpulver gezüchtet wird.

4. Verfahren nach Anspruch 3, **dadurch gekennzeichnet, dass** zur Einleitung des Züchtungsvorgangs und/oder zur Züchtung der Kristallbirne (14) zwischen den Züchtungsvorgängen mit Metalloxidpulvern aus der Asche einzelner biogener Körper ein gleichartiges, undotiertes Metalloxidpulver eingesetzt wird.
